Europäisches Patentamt

European Patent Office

Office européen des brevets

(11) Numéro de publication: **0 298 301 B1**

## FASCICULE DE BREVET EUROPEEN

(45) Date de publication de fascicule du brevet: **08.04.92**  (51) Int. Cl.5: **H03H 15/02**

(21) Numéro de dépôt: **88109897.4**

(22) Date de dépôt: **22.06.88**

(54) **Procédé de réalisation de filtres adaptés programmables, filtres et bancs de filtres correspondants.**

(30) Priorité: **26.06.87 FR 8709040**

(43) Date de publication de la demande:
**11.01.89 Bulletin 89/02**

(45) Mention de la délivrance du brevet:
**08.04.92 Bulletin 92/15**

(84) Etats contractants désignés:
**CH DE ES FR GB IT LI SE**

(56) Documents cités:
**US-A- 4 338 581**

**THE TRANSACTIONS OF THE IECE OF JA-
PAN, vol. E 59, no. 8, août 1976, page 10,
Tokyo, JP; H. KOSUGI: "High-pass and bandelimination filter using frequency-sampling
technique"**

**DER ELEKTRONIKER, vol. 15, no. 6, juin 1976,
pages EL7-EL12, Aurau, CH; O. MÜLLER:
"Semiconductor filter on a chip or sampleddata filter using charge coupled device"**

**IEEE JOURNAL OF SOLID-STATE CIRCUITS,
vol. SC-16, no. 3, juin 1981, pages 125-129,
IEEE, New York, US; R. SCHREIBER et al.:
"Passive CCD resonator filters"**

(73) Titulaire: **Société Anonyme dite: CEGELEC
13, rue Antonin Raynaud
F-92309 Levallois-Perret(FR)**

(72) Inventeur: **Tresset, Alain
34, rue du Haras
F-91240 Saint Micel Sur Orge(FR)**
Inventeur: **Javard, Gérard
37, Boulevard Saint Michel
F-91600 Savigny Sur Orge(FR)**
Inventeur: **Fontenelle, François
18, rue des Crocheteurs
F-92160 Antony(FR)**

(74) Mandataire: **Weinmiller, Jürgen et al
Lennéstrasse 9 Postfach 24
W-8133 Feldafing(DE)**

## Description

La présente invention concerne un procédé de réalisation de filtres adaptés programmables, notamment pour récepteur de signaux télégraphique d'équipement de téléprotection -ou téléaction-. Elle concerne également les filtres et bancs de filtres ainsi réalisés.

Il est classique, dans les réseaux de transport d'énergie électrique sous forte tension, d'échanger des informations entre les postes situés aux extrémités des lignes de transport de l'énergie par l'intermédiaire de ces lignes, notamment pour la commande des appareillages des postes et pour la signalisation des défauts.

L'échange d'informations s'effectue souvent sous forme télégraphique par modulation d'amplitude, de fréquence ou de phase de signaux de fréquence prédéterminées, notamment selon des techniques désignées respectivement par les sigles anglais ASK, FSK ou MFSK, PSK ou DPSK. Le nombre de fréquences prédéterminées varie selon la technique et se réduit à une dans les cas les plus simples.

Pour différentes raisons les fréquences prédéterminées, retenues pour transmettre les informations, sont généralement choisies dans la bande téléphonique et viennent alors moduler des ondes porteuses haute fréquence qui sont envoyées sur les lignes de transport d'énergie ; le choix de la bande téléphonique permet aussi de transmettre ces fréquences par voie téléphonique, si cela est jugé souhaitable. Les transmissions d'informations effectuées par les lignes de transport d'énergie sont susceptibles de s'effectuer dans des conditions très mauvaises, si les lignes de transport sont perturbées par suite de parasites ou défauts électriques.

Or les équipements de téléprotection destinés à recevoir ces informations doivent avoir un fonctionnement le plus sûr possible dans les pires conditions possibles si l'on veut qu'ils remplissent leur rôle, notamment pour la commande des appareillages de protection.

Ceci implique, entre autres, une très grande sûreté de reconnaissance des récepteurs de signaux télégraphiques chargés de récupérer les informations transmises et par conséquent un filtrage fréquentiel très efficace pour extraire les signaux utiles du bruit parasite où ils sont noyés. On est donc conduit à chercher à réaliser des filtres adaptés, pour éliminer le bruit et favoriser les signaux dont la fréquence correspond à l'une des fréquences prédéterminées.

Il est de plus souhaitable de pouvoir constituer des bancs de filtres identiques, accordés sur des fréquences différentes ou de pouvoir modifier simplement l'adaptation des filtres à la demande pour permettre aux utilisateurs de choisir les fréquences prédéterminées dont ils ont besoin sans avoir à modifier la constitution des filtres, comme cela est nécessaire si ceux-ci sont réalisés en technique analogique classique.

A cet effet la présente invention propose donc un procédé de réalisation de filtres adaptés programmables, notamment pour récepteur de signaux télégraphiques d'équipement de téléprotection, ainsi que les filtres et bancs de filtres correspondants.

Selon une caractéristique du procédé selon l'invention, on réunit en un même filtre adapté, un résonateur à grande sélectivité, organisé autour d'un filtre multivoie que l'on commande par un premier signal d'horloge au moyen duquel la fréquence centrale du filtre adapté est fixée, et un filtre en peigne organisé autour d'une ligne à retard, de type à transfert de charges que l'on commande par un second signal d'horloge au moyen duquel la largeur de bande du filtre adapté est fixée.

Selon une caractéristique des filtres selon l'invention, chaque filtre adapté et programmable comporte au moins un résonateur à grande sélectivité, organisé autour d'un filtre multivoie, et au moins un filtre en peigne, organisé autour d'un ligne à retard de type à transfert de charges, qui sont commandés par des signaux d'horloge au moyen desquels la fréquence de résonance du résonateur et la largeur de lobe du filtre en peigne sont fixées, les fréquences respectives du signal d'horloge appliqué au filtre en peigne et du signal d'horloge appliqué au résonateur étant choisies telles que ladite fréquence de résonance soit égale à un multiple entier de ladite largeur de lobe.

L'invention, ses caractéristiques et ses avantages sont décrits dans la description qui suit, en liaison avec les figures répertoriées ci-dessous.

Comme indiqué plus haut, le procédé de réalisation selon l'invention est plus particulièrement destiné à être exploité pour l'obtention de filtres et bancs de filtres adaptés programmables, en particulier pour ceux qui sont destinés à être placés en entrée des récepteurs de signaux télégraphiques que l'on trouve dans les équipements de téléprotection des réseaux de distribution d'énergie électrique sous tension élevée.

Classiquement les équipements de téléprotection sont placés dans les postes situés aux extrémités des lignes de transport d'énergie, tel le poste 1 supposé placé en extrémité d'une ligne triphasée de transport d'énergie L1 d'un réseau maillé.

Le poste 1 comporte classiquement des disjoncteurs de protection 2 permettant d'ouvrir la ligne en cas de besoin.

Ces disjoncteurs 2 sont commandés par un équipement de protection 3 doté notamment de moyens de mesure électrique, comme le symbolise le transformateur de mesure 4 et de moyens de communication tant en émission qu'en réception, en particulier avec le poste, non figuré, situé à l'autre extrémité de la ligne triphasée L1.

A cet effet l'équipement de protection 3 est relié à un équipement de téléprotection 5 avec lequel il échange ces informations sous forme binaire au moyen de signaux électriques de type tout ou rien.

L'équipement de téléprotection 5 est destiné à permettre la transmission des informations entre les postes concernés, ce qui implique usuellement une conversion des signaux tout ou rien en signaux transmissibles à grande distance et récupérables malgré le bruit existant où ils sont noyés.

Divers types d'équipements de téléprotection 5 peuvent être envisagés. Dans une forme classique les signaux tout ou rien produits par l'équipement de protection 3 sont convertis en signaux télégraphiques codés par modulation d'amplitude, de fréquence ou de phase dans la bande téléphonique, à l'intérieur d'un canal de cette bande. Réciproquement l'équipement de téléprotection 5 est apte à recevoir et reconnaître les informations transmises sous forme, télégraphique par modulation d'amplitude, de fréquence ou de phase, à partir de l'équipement de téléaction, non représenté, desservant le poste situé à l'autre extrémité de la ligne triphasée L1, de manière à commander en conséquence l'équipement de protection 3, sous une forme acceptable par ce dernier.

Pour effectuer ces opérations l'équipement de téléprotection 5 comporte un étage basse fréquence d'émission 6 qui reçoit les signaux de l'équipement de protection 3 et les convertit en signaux codés basse fréquence, ainsi qu'un étage basse fréquence de réception 7 qui convertit les signaux codés basse fréquence provenant au poste 1 en signaux de commande en tension ou courant.

L'entrée des signaux télégraphiques dans l'étage basse fréquence de réception 7 s'effectue au travers d'au moins un filtre 8 pour extraire du bruit ambiant les basses fréquences prédéterminées qui correspondent aux codes choisis par l'exploitant du réseau de transport d'énergie pour ses besoins.

Ce filtre 8 est ici adapté, programmable et piloté par une horloge 0.

La sortie de l'étage basse fréquence d'émission 6 et l'entrée du filtre adapté 8 sont susceptibles d'être reliées à divers moyens de transmission en vue de l'échange des informations du poste 1 avec le poste, non figuré, situé à l'autre extrémité de la ligne triphasée L1.

Ce moyen de transmission peut être une ligne téléphonique réservée LT d'un réseau téléphonique public ou privé, cela peut également être la ligne triphasée L1 elle-même, en particulier lorsqu'il n'y a pas de liaison téléphonique existant entre les deux postes concernés.

L'envoi des signaux codés basse fréquence s'effectue par exemple par l'intermédiaire d'un canal d'un classique système 10 à courants porteurs sur ligne d'énergie, qui est relié à la ligne triphasée L1 et qui est situé à l'extérieur de l'équipement de téléprotection 5. Cet envoi de signaux codés basse fréquence peut également s'effectuer à l'aide d'une partie haute fréquence 9 regroupant un étage émetteur et un étage récepteur qui assurent, d'une part, la transposition des signaux codés basse fréquence en signaux haute fréquence pour transmission par la ligne triphasée L1, d'autre part, la transposition inverse.

La connexion de la partie haute fréquence 9 ou du système à courants porteurs 10 avec la ligne triphasée L1 s'effectue par l'intermédiaire d'une classique boîte de couplage 11 reliée à un fil de la ligne triphasée L1, via un condensateur de couplage 12 associé à une inductance 13 d'écoulement à la terre.

Un circuit bouchon, composé d'une inductance 14 et d'un condensateur 15, limite classiquement la transmission des signaux haute fréquence modulés à la seule partie de fil de liaison triphasée L1 qui joint le poste 1 au poste situé à l'autre extrémité de cette liaison triphasée.

On conçoit aisément qu'une telle transmission puisse être fortement parasitée en diverses circonstances où il est important qu'elle fonctionne correctement, par exemple lors des commandes de disjoncteurs.

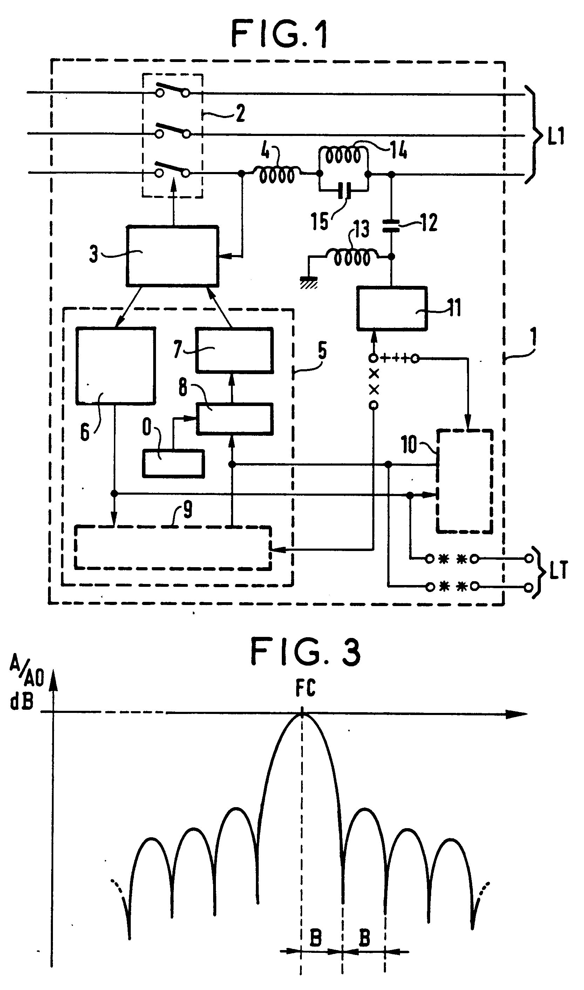

On recherche donc à filtrer les signaux reçus par l'étage basse fréquence de réception 7 au moyen d'au moins un filtre 8. Pour optimiser le résultat, on est donc conduit à utiliser un filtre ou un banc de filtres adaptés permettant de favoriser la où les basses fréquences prédéterminées de codage qui ont été choisies par l'exploitant du réseau. La réponse fréquentielle d'un tel filtre est donnée par la figure 3.

Ce filtrage pour une basse fréquence déterminée s'effectue selon l'invention en associant un résonateur, tel 16 ou 16″, à grande sélectivité centré sur la fréquence, dite centrale, Fc avec un filtre en peigne, tel 17′ ou 17″, dont l'une des fréquences d'atténuation maximale corresponde à la fréquence Fc.

Dans une première variante de réalisation présentée figure 2, le résonateur 16 est placé en amont du filtre en peigne 17 dans le filtre adapté ici référencé 8′.

Un filtre multivoie 18 constitue l'élément essentiel autour duquel est organisé le résonateur 16. Ce filtre multivoie comporte par exemple quatre voies composées chacune d'un élément passe-bas H (jw) et successivement commutées de manière connue en soi au rythme d'un signal d'horloge de fréquence Hc fourni par l'horloge 0. Cette dernière est classiquement constituée par une horloge à quartz procurant une grande stabilité et un synthétiseur de fréquence permettant de générer les signaux d'horloge requis tel Hc à partir du signal de l'horloge à quartz.

Chaque élément passe-bas de voie du filtre 18 est par exemple composé à l'aide d'un intégrateur actif ou d'un simple circuit RC.

La fréquence Hc est choisie ici égale a deux fois la fréquence Fc désirée pour le résonateur 16, le filtre ayant quatre voies, comme indiqué plus haut.

Ceci permet donc de réaliser un résonateur à grande sélectivité, aisément programmable à une fréquence de résonance déterminée par simple modification de la fréquence Hc qui le pilote en commutant successivement ses voies, cette modification étant obtenue de manière connue en soi par action sur le synthétiseur de fréquence non représenté de l'horloge 0.

Comme le filtre multivoie 18 agit par échantillonnage, il est nécessaire de lui associer en amont un filtre anti-repliement de spectre 19 limitant le spectre des signaux reçus de manière à satisfaire à la condition posée par le théorème de Shannon.

On associe également un filtre de lissage 20 au filtre multivoie 18 en sortie de ce dernier pour lisser les signaux en escalier fournis.

Dans l'exemple de réalisation proposé, le filtre anti-repliement 19 et le filtre de lissage 20 sont respectivement pilotés par deux signaux d'horloge auxiliaires Ha1 et Ha2 et sont constitués l'un et l'autre sous la forme de passe-bas, à capacités commutées au rythme des signaux d'horloge ; ils sont donc également programmables.

Bien entendu ce filtre anti-repliement et ce filtre de lissage peuvent aussi être des filtres fixes, suivant les besoins.

Selon l'invention, on associe de plus au résonateur 16 un filtre en peigne 17 organisé autour d'une ligne à retard 21 du type à transfert de charges.

Cette ligne à retard 21 comporte un nombre P de pas, par exemple 1024 pas ; son retard T est programmable par action sur la fréquence du signal d'horloge Hb qui lui est fourni par l'horloge 0.

Dans une première variante de réalisation de filtre en peigne, la ligne à retard 21 est reliée par son entrée à la sortie d'un amplificateur inverseur 22 et par sa sortie à une première entrée d'un sommateur 23 dont une seconde entrée reçoit, en parallèle avec l'amplificateur inverseur 22, le signal issu de résonateur 16.

Un autre filtre anti-repliement de spectre 24 et un autre filtre de lissage 25 sont respectivement placés le premier en amont et le second en aval de l'ensemble formé par l'amplificateur inverseur 22, la ligne à retard 21 et le sommateur 23, ils ont même rôle pour cet ensemble que les filtres 19 et 20 pour le filtre multivoie 18. Des signaux d'horloge Ha3, Ha4 pilotent respectivement chacun des filtres 24 et 25.

La réponse en amplitude du filtre adapté 8' en fonction de la fréquence est montrée par la figure 3.

Comme indiqué plus haut la fréquence centrale est fixée par le résonateur 16 et plus précisément par la fréquence Hc du signal d'horloge appliqué à ce résonateur. La largeur du lobe B, égale à l'inverse du retard T, est fixée par la ligne à retard 21 et plus précisément par la fréquence Hb pilotant cette ligne, sachant que B = Hb/P.

Le choix de la largeur de lobe détermine la vitesse de réponse du filtre.

On s'arrange pour que la fréquence de résonance du résonateur 16 coïncide avec l'une des fréquences pour laquelle l'atténuation du filtre en peigne 17 est maximale.

Il est possible de faire varier la fréquence de chacun des signaux d'horloge Ha et Hb à partir du moment où l'on conserve l'égalité Fc = k.B dans laquelle k est un nombre entier positif.

La variante évoquée ci-dessus peut-être adaptée en vue de permettre le filtrage sélectif de plusieurs basses fréquences prédéterminées par mise en parallèle de filtres adaptés identiques pilotés par des signaux d'horloge différents, l'ensemble formant un banc de filtres fixes ou programmables suivant les besoins.

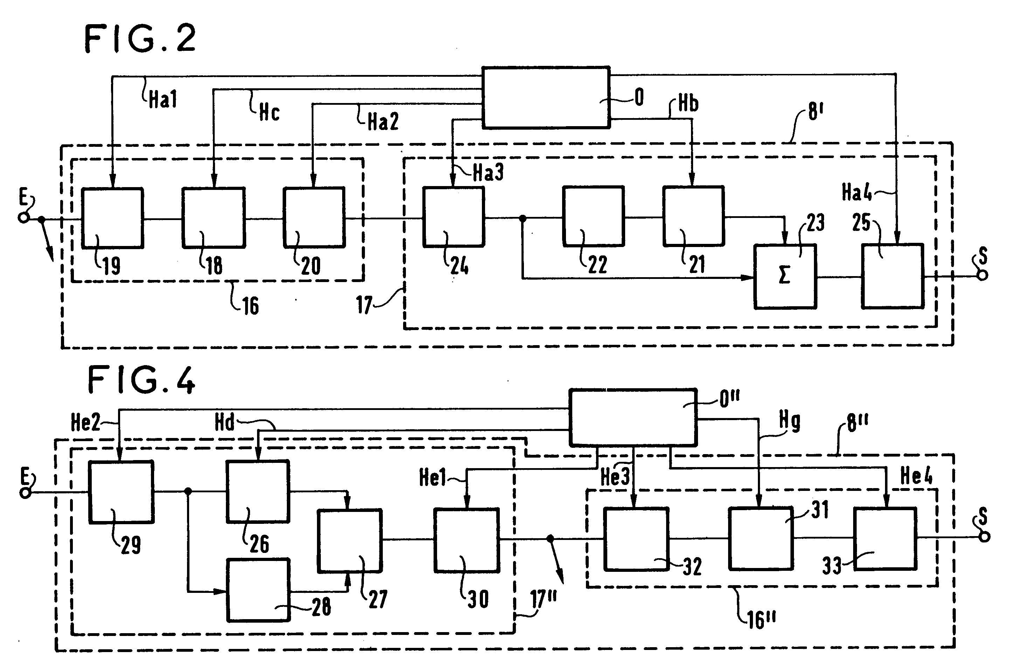

La variante de réalisation présentée figure 4, tout en permettant la reconnaissance d'une basse fréquence prédéterminée unique, permet aussi de limiter à un seul le nombre de filtres en peigne dans le cas où il y a plusieurs basses fréquences prédéterminées à sélectionner à l'arrivée.

Le filtre adapté ou banc de filtres adaptés 8″ obtenu comporte au moins un filtre en peigne 17″ et un ou plusieurs résonateurs 16″ en aval du filtre en peigne ; une horloge 0″ analogue à l'horloge 0 est utilisée pour programmer le filtre adapté 8″ selon les besoins.

Le filtre en peigne 17″ est organisé lui aussi autour d'une ligne à retard 26 de type à transfert de charges qui est pilotée par un signal d'horloge de fréquence Hd.

La structure du filtre en peigne 17″ est éventuellement identique à celle du filtre en peigne 17 de la figure 2.

Dans la variante de réalisation présentée figure 4, un sommateur 27 a ses deux entrées respectivement reliées l'une en sortie de la ligne à retard 26, l'autre en sortie d'un amplificateur inverseur 28, la ligne à retard et l'amplificateur inverseur étant connectés en parallèle en sortie d'un filtre anti-

remplacement de spectre 29 placé en entrée de filtre adapté 8″ pour recevoir les signaux à traiter. Bien entendu, cette variante de réalisation de filtre en peigne telle que présentée figure 4 peut également être mise en oeuvre à la place de celle présentée figure 2 dans le cadre défini par cette figure 2.

Dans l'exemple proposé figure 4, un filtre de lissage 30 est placé en sortie du sommateur 27 ; il est piloté par un signal d'horloge He1 que lui fournit l'horloge 0″, qui fournit également un signal d'horloge He2 au filtre anti-repliement 29.

Le filtre en peigne 17″ ainsi obtenu est programmé de façon analogue à celle prévue pour le filtre en peigne 17 et fournit classiquement une réponse en amplitude comportant une série d'arches de même largeur et de même amplitude dans la bande basse fréquence téléphonique choisie.

La sortie du filtre en peigne 17″ est reliée ici à un seul résonateur 16″, étant entendu que plusieurs résonateurs centrés sur des fréquences différentes sont susceptibles d'être connectés en parallèle à cette sortie, si le filtrage sélectif de plusieurs basses fréquences est envisagé, l'ensemble formant un banc de filtres fixes ou programmables selon les besoins.

Le résonateur 16″ est organisé autour d'un filtre multivoie 31 qui est analogue au filtre multivoie 18 évoqué plus haut et qui est ici piloté par un signal d'horloge de fréquence Hg produit par l'horloge 0″.

Un filtre anti-repliement 32 et un filtre de lissage 33 sont respectivement montés l'un entre le résonateur 17″ et le filtre multivoie 31, l'autre en aval de ce dernier, ils sont respectivement pilotés chacun par un des deux signaux d'horloge He3 et He4 de l'horloge 0″.

On peut éventuellement combiner le filtre de lissage 30 avec le filtre anti-repliement 32, comme il était également possible de le faire pour les filtres 20 et 24 de la variante de la figure 1.

Lorsque plusieurs résonateurs tels que 16″ sont placés en parallèle en sortie du filtre en peigne 17″ on s'arrange pour programmer les signaux d'horloge de fréquence Hg1, Hg2, Hg3... qui fixent leurs fréquences de résonance respectives, de manière que les conditions définies pour un filtre en peigne et un résonateur, en relation avec la variante précédente restent vérifiées.

Dans l'un et l'autre cas, il est donc possible de programmer un filtre selon l'invention par action sur les fréquences de signaux d'horloge qui lui sont fournis.

Bien entendu, il est aussi possible de réaliser selon le même procédé des bancs de filtres composés d'une pluralité de filtres en peignes qui reçoivent en parallèle le signal à traiter et qui attaquent chacun l'entrée d'un résonateur différent, selon une forme de réalisation simple à concevoir et ici non représentée.

## Revendications

1. Procédé de réalisation de filtres adaptés pour récepteur d'informations transmises sous forme télégraphique par modulation d'amplitude, de fréquence ou de phase, caractérisé en ce que, dans le but d'obtenir des filtres susceptibles d'être programmés à la demande, on réunit en cascade en un même filtre adapté (8), au moins un résonateur à grande sélectivité (16), organisé autour d'un filtre multivoie (18), que l'on commande par un premier signal d'horloge au moyen duquel la fréquence centrale du filtre adapté est fixée, et au moins un filtre en peigne (17) organisé autour d'une ligne à retard (21), de type à transfert de charges, que l'on commande par un second signal d'horloge au moyen duquel la largeur de lobe du filtre adapté est fixée.

2. Filtre adapté programmable pour récepteur d'informations transmises sous forme télégraphique par modulation d'amplitude, de fréquence ou de phase, notamment pour équipement de téléprotection, caractérisé en ce qu'il comporte, au moins, un résonateur à grande sélectivité (16, 16″) organisé autour d'un filtre multivoie (18, 31), et au moins un filtre en peigne (17, 17″), organisé autour d'une ligne à retard (21, 26) de type à transfert de charges, qui sont commandés par des signaux d'horloge au moyen desquels la fréquence de résonance du résonateur et la largeur de lobe du filtre en peigne sont fixées, les fréquences respectives du signal d'horloge appliqué au filtre en peigne et du signal d'horloge appliqué au résonateur étant choisies telles que la fréquence de résonance du résonateur soit égale à un multiple entier de la largeur de lobe.

3. Filtre adapté programmable selon la revendication 2, caractérisé en ce que le filtre en peigne comporte une ligne à retard (26), de type à transfert de charges et un amplificateur inverseur (28), interconnectés par leurs entrées de signal à traiter et individuellement reliés par leurs sorties aux entrées d'un sommateur (27).

4. Filtre adapté programmable selon la revendication 2, caractérisé en ce qu'il comporte un filtre en peigne doté d'un sommateur (23) qui reçoit le signal à traiter d'une part directement par une première entrée, d'autre part via un amplificateur inverseur (22) et la ligne à retard (21), en cascade, par une seconde entrée.

5. Filtre adapté programmable selon l'une des revendications 3 ou 4, caractérisé en ce qu'il comporte d'une part un filtre en peigne (17 ou 17″) doté d'une part d'un filtre anti-repliement (24 ou 29) en amont de l'entrée de l'ensemble formé par l'amplificateur inverseur, la ligne à retard et le sommateur d'autre part un filtre de lissage (25 ou 30) en aval du sommateur (23 ou 27).

6. Filtre adapté programmable selon la revendication 2, caractérisé en ce qu'il comporte au moins un résonateur (16 ou 16″) composé d'un filtre anti-repliement (19 ou 32), d'un filtre multivoie (18 ou 31) et d'un filtre de lissage (20 ou 33) en cascade.

7. Banc de filtres adaptés programmables composé à partir d'un filtre selon la revendication 2 et caractérisé en ce qu'il comporte autant de résonateurs qu'il y a de basses fréquences de modulation à sélectionner, chaque résonateur étant connecté par sa sortie à l'entrée d'un filtre en peigne (17) avec lequel il forme une unité de filtrage, chaque unité de filtrage composée d'un résonateur et d'un filtre en peigne étant accordée sur une basse fréquence de modulation à sélectionner, par des signaux d'horloge respectivement appliqués l'un au résonateur, l'autre au filtre en peigne, de manière que la fréquence de résonance du résonateur corresponde à l'une des fréquences d'atténuation maximale du filtre en peigne.

8. Banc de filtres adaptés programmables composé à partir d'un filtre selon la revendication 2, caractérisé en ce qu'il comporte un filtre en peigne (17″) en sortie duquel est connecté un ensemble de "n" résonateurs (16″), montés en parallèle dont les fréquences de résonance respectives, correspondant aux basses fréquences de modulation à sélectionner, sont fixées de manière à correspondre aux fréquences d'atténuation maximale du filtre en peigne sous l'action de signaux d'horloge individuels fournis sélectivement aux résonateurs ou au filtre en peigne.

9. Banc de filtres adaptés et programmables composé à partir d'un filtre selon la revendication 2, caractérisé en ce qu'il comporte une pluralité de filtres en peigne recevant en parallèle le signal à traiter et attaquant chacun l'entrée d'un résonateur différent.

**Claims**

1. Method of implementing tuned filters for a receiver of information transmitted telegraphically by modulating amplitude, frequency, or phase, the method being characterized in that in order to obtain filters suitable for being programmed on request, a single tuned filter (8) combines, in cascade, at least one high-selectivity resonator (16) organized about a multipath filter (18), which is controlled by a first clock signal, whereby the center frequency of the tuned filter is fixed, and at least one comb filter (17) organized about a delay line (21) of the charge transfer type, which is controlled by a second clock signal, whereby the lobe width of the tuned filter is fixed.

2. A programmable tuned filter for receiving information transmitted telegraphically by modulating amplitude, frequency, or phase, in particular for remote protection equipment, the filter being characterized in that it comprises at least one high-selectivity resonator (16, 16") organized around a multipath filter (18, 31), and at least one comb filter (17, 17") organized about a delay line (21, 26) of the charge transfer type, said resonator and comb filter being controlled by clock signals which fix the resonance frequency of the resonator and the lobe width of the comb filter, with the frequency of the clock signal applied to the comb filter and frequency of the clock signal applied to the resonator being selected in such a manner that the resonance frequency of the resonator is equal to an integer multiple of the lobe width.

3. A programmable tuned filter according to claim 2, characterized in that the comb filter comprises a delay line (26) of the charge transfer device and an inverting amplifier (28) which have their inputs interconnected to receive the signals to be processed and which have their outputs connected to respective inputs of a summing circuit (27).

4. A programmable tuned filter according to claim 2, characterized in that it includes a comb filter provided with a summing circuit (23) which receives the signal to be processed firstly directly on a first input and secondly, on a second input, via an inverting amplifier (22) and the delay line (21) connected in cascade.

5. A programmable tuned filter according to claim 3 or 4, characterized in that it includes a comb filter (17 or 17") provided firstly with an antifolding filter (24 or 29) upstream from the input to the assembly constituted by the inverting amplifier, the delay line, and the summing circuit, and secondly a smoothing filter (25 or 30) downstream from the summing circuit (23 or 27).

6. A programmable tuned filter according to claim 2, characterized in that it includes at least one resonator (16 or 16") constituted by an antifolding filter (19 or 32), a multipath filter (18 or 31) and a smoothing filter (20 or 33) connected in cascade.

7. A bank of programmable tuned filters constituted by filters according to claim 2, and characterized in that it comprises as many resonators as there are modulation low frequencies to be selected, with each resonator having its output connected to the input of a comb filter (17) with which it constitutes a filter unit, with each filter unit constituted by a resonator and a comb filter being tuned to a modulation low frequency to be selected by means of clock signals, one of which is applied to the resonator and the other of which is applied to the comb filter, in such a manner as to cause the resonance frequency of the resonator to correspond with one of the frequencies of maximum attenuation of the comb filter.

8. A bank of programmable tuned filters based on a filter according to claim 2, characterized in that it comprises a comb filter (17") having a set of n resonators (16") connected in parallel to its output, said resonators having respective resonance frequencies corresponding to the modulation low frequencies to be selected and fixed in such a manner as to correspond to different frequencies of maximum attenuation of the comb filter by means of individual clock signals applied selectively to the resonators and to the comb filter.

9. A bank of programmable tuned filters based on a filter according to claim 2, characterized in that it comprises a plurality of comb filters receiving the signal to be processed in parallel and each feeding the input of a different resonator.

**Patentansprüche**

1. Verfahren zur Herstellung von Filtern, die für den Empfang von Informationen geeignet sind, welche telegraphisch durch Amplituden-, Frequenz- oder Phasenmodulation übertragen werden, dadurch gekennzeichnet, daß zur Erzielung von auf Anforderung programmierbaren Filtern in einem gemeinsamen abgestimmten Filter (8) mindestens ein trennscharfer Resonator (16), der um ein Vielkanalfilter (18) ausgebildet und durch ein erstes Taktsignal gesteuert wird, mit dessen Hilfe die Mittenfrequenz des abgestimmten Filters festgelegt wird, sowie ein Kammfilter (17) in Kaskade geschaltet werden, das um eine Verzögerungsleitung (21) vom Ladungstransfertyp ausgebildet und von einem zweiten Taktsignal gesteuert wird, mit dessen Hilfe die Breite des Durchlaßbereichs des abgestimmten Filters fixiert wird.

2. Programmierbares, abgestimmtes Filter für einen Empfänger von Informationen, die in telegraphischer Form durch Amplituden-, Frequenz- und Phasenmodulation übertragen werden, insbesondere für Fernschutzeinrichtungen, dadurch gekennzeichnet, daß das Filter mindestens einen trennscharfen Resonator (16, 16"), der um ein Vielkanalfilter (18, 31) ausgebildet ist, und ein Kammfilter (17, 17") aufweist, das eine Verzögerungsleitung (21, 26) vom Ladungstransfertyp aufweist, wobei diese Organe durch Taktsignale gesteuert werden, mit deren Hilfe der Resonanzfrequenz des Resonators und die Breite des Durchlaßbereichs des Kammfilters festgelegt werden, und wobei die jeweiligen Frequenzen des an das Kammfilter und an den Resonator angelegten Taktsignals so gewählt ist, daß die Resonanzfrequenz des Resonators ein ganzzahliges Vielfaches der Breite des Durchlaßbereichs ist.

3. Programmierbares, abgestimmtes Filter nach Anspruch 2, dadurch gekennzeichnet, daß das Kammfilter eine Verzögerungsleitung (26) vom Ladungstransfertyp und einen Umkehrverstärker (28) aufweist, die durch ihre Eingänge für das zu verarbeitende Signal miteinander verbunden sowie mit ihren Ausgängen einzeln an die Eingänge eines Summierglieds (27) angeschlossen sind.

4. Programmierbares, abgestimmtes Filter nach Anspruch 2, dadurch gekennzeichnet, daß es ein Kammfilter mit einem Summierglied (23) aufweist, das das zu verarbeitende Signal über einen ersten Eingang direkt und an einem zweiten Eingang über einen Umkehrverstärker (22) in Kaskade mit der Verzögerungsleitung (21) zugeführt erhält.

5. Programmierbares, abgestimmtes Filter nach Anspruch 3 oder 4, dadurch gekennzeichnet, daß es zum einen ein Kammfilter (17, 17") mit einem Antifaltungsfilter (24 oder 29) vor dem Eingang der vom Umkehrverstärker, der Verzögerungsleitung und dem Summierglied gebildeten Gruppe, und zum anderen ein Glättungsfilter (25 oder 30) hinter dem Summierglied aufweist.

6.	Programmierbares, abgestimmtes Filter nach Anspruch 2, dadurch gekennzeichnet, daß es mindestens einen Resonator (16 oder 16") aufweist, der aus einem Antifaltungsfilter (19 oder 32), einem Vielkanalfilter (18 oder 33) und einem Glättungsfilter (20 oder 22) in Kaskadenschaltung besteht.

7.	Programmierbare, abgestimmte Filterbank, die beginnend mit einem Filter nach Anspruch 2 aufgebaut ist, dadurch gekennzeichnet, daß sie ebensoviele Resonatoren aufweist, wie es auszuwählende niedrige Modulationsfrequenzen gibt, wobei jeder Resonator mit seinem Ausgang an den Eingang eines Kammfilters (17) angeschlossen ist, mit welchem er eine Filtereinheit bildet, und jede aus einem Resonator und einem Kammfilter bestehende Filtereinheit mit Hilfe von Taktsignalen auf eine zu wählende niedrige Modulationsfrequenz abgestimmt ist, wobei ein Taktsignal an den Resonator und das andere an das Kammfilter angelegt ist, derart, daß die Resonanzfrequenz des Resonators einer der Frequenzen maximaler Dämpfung des Kammfilters entspricht.

8.	Programmierbare, abgestimmte Filterbank, die beginnend mit einem Filter nach Anspruch 2 aufgebaut ist, dadurch gekennzeichnet, daß sie ein Kammfilter (17") aufweist, an dessen Ausgang eine Gruppe von "n" Resonatoren (16") parallel angeschlossen ist, deren jeweilige, den auszuwählenden niedrigen Resonanzfrequenzen entsprechende Resonanzfrequenzen derart fixiert werden, daß sie unter der Einwirkung von individuellen Taktsignalen, die selektiv an die Resonatoren oder an das Kammfilter geliefert werden, den Frequenzen maximaler Dämpfung des Kammfilters entsprechen.

9.	Programmierbare, abgestimmte Filterbank, die beginnend mit einem Filter nach Anspruch 2 aufgebaut ist, dadurch gekennzeichnet, daß sie eine Vielzahl von Kammfiltern aufweist, die parallel das zu verarbeitende Signal empfangen und die je den Eingang eines unterschiedlichen Resonators speisen.

# FIG.1

# FIG. 3

# FIG.2

# FIG.4

EP 0 298 301 B1